(19) Europäisches Patentamt
European Patent Office
Office européen des brevets

(11) EP 4 797 347 A1

(12) **EUROPEAN PATENT APPLICATION**
published in accordance with Art. 153(4) EPC

(43) Date of publication:
**26.08.2026 Bulletin 2026/35**

(21) Application number: **24878404.3**

(22) Date of filing: **23.04.2024**

(51) International Patent Classification (IPC):
***H01M 4/36*** *(2006.01)* ***H01M 4/38*** *(2006.01)*
***H01M 4/583*** *(2010.01)* ***H01M 4/62*** *(2006.01)*
***H01M 10/0525*** *(2010.01)* ***C01B 32/05*** *(2017.01)*
***C01B 33/029*** *(2006.01)*

(52) Cooperative Patent Classification (CPC):
**C01B 32/05; C01B 33/029; H01M 4/36; H01M 4/38; H01M 4/583; H01M 4/62; H01M 10/0525;**
Y02E 60/10

(86) International application number:
**PCT/CN2024/089369**

(87) International publication number:
**WO 2025/081751 (24.04.2025 Gazette 2025/17)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **20.10.2023 CN 202311360972**

(71) Applicant: **Contemporary Amperex Technology Co., Limited**
**Ningde, Fujian 352100 (CN)**

(72) Inventors:
- **CHEN, Wenqiang**
**Ningde, Fujian 352100 (CN)**
- **WANG, Jiazheng**
**Ningde, Fujian 352100 (CN)**
- **LV, Zijian**
**Ningde, Fujian 352100 (CN)**
- **SU, Yingwei**
**Ningde, Fujian 352100 (CN)**

(74) Representative: **Gong, Jinping**
**CocreateIP**
**Neumarkter Straße 21**
**81673 München (DE)**

# (54) SILICON-CARBON COMPOSITE MATERIAL AND PREPARATION METHOD THEREFOR, SECONDARY BATTERY, AND ELECTRIC DEVICE

(57) A silicon-carbon composite material and a preparation method thereof, a secondary battery, and an electric apparatus are provided. The silicon-carbon composite material includes a carbon matrix having a pore structure and a silicon-based material distributed in the pore structure. A button battery is used to charge and discharge the silicon-carbon composite material, a curve graph of a relationship between a differential value dQ/dV obtained by differentiating a voltage V of a charge-discharge curve of the button battery with respect to a charge-discharge capacity Q and the voltage V is plotted, a maximum value of the differential value dQ/dV within a range of 0.26 V-0.35 V is denoted as $V_A$, a maximum value of the differential value dQ/dV within a range of 0.42 V-0.52 V is denoted as $V_B$, and the silicon-carbon composite material satisfies: $V_A/V_B \geq 1.40$. The cycling performance and first-cycle charge-discharge efficiency of the silicon-carbon composite material can be significantly improved.

6000
5000
4000
3000
2000
1000
0
dQ/dV (mAh/V)
0
0.5
1
1.5
2
Voltage (V)
FIG. 5



Processed by Luminess, 75001 PARIS (FR)

## Description

### CROSS-REFERENCE TO RELATED APPLICATIONS

This application claims priority to Chinese Patent Application No. 202311360972.7, filed on October 20, 2023 and entitled "SILICON-CARBON COMPOSITE MATERIAL AND PREPARATION METHOD THEREOF, SECONDARY BATTERY, AND ELECTRIC APPARATUS", which is incorporated herein by reference in its entirety.

### TECHNICAL FIELD

This application relates to the field of secondary battery technology, and in particular, to a silicon-carbon composite material and a preparation method thereof, a secondary battery, and an electric apparatus.

### BACKGROUND

Secondary batteries have extremely wide applications in fields such as portable electronic devices and electric vehicles. With the continuous development of the new energy industry, users have put forward increasingly high usage requirements for secondary batteries, for example, high energy density.

Silicon-based materials are widely used in secondary batteries due to their high capacity. However, silicon has the characteristic of high swelling and poor conductivity, silicon-based materials affect the cycling performance of secondary batteries while increasing the energy density of secondary batteries, limiting the further development of battery technology.

### SUMMARY

In view of this, it is necessary to provide a silicon-carbon composite material and a preparation method thereof, a secondary battery, and an electric apparatus, to alleviate the swelling of the secondary battery and improve the cycling performance of the secondary battery.

In order to achieve the above objective, a first aspect of this application provides a silicon-carbon composite material including:

a carbon matrix, where the carbon matrix has a pore structure; and
a silicon-based material distributed in the pore structure of the carbon matrix;
where a button battery is used to charge and discharge the silicon-carbon composite material, a curve graph of a relationship between a differential value dQ/dV obtained by differentiating a voltage V of a charge-discharge curve of the button battery with respect to a charge-discharge capacity Q and the voltage V is plotted, a maximum value of the differential value dQ/dV within a range of 0.26 V-0.35 V is denoted as $V_A$, a maximum value of the differential value dQ/dV within a range of 0.42 V-0.52 V is denoted as $V_B$, and the silicon-carbon composite material satisfies: $V_A/V_B \geq 1.40$.

In the silicon-carbon composite material of this application, at least part of the silicon-based material is distributed in the pore structure of the carbon matrix. The carbon matrix can improve the conductivity of the silicon-based material and can also serve as a buffer medium for the volume swelling of the silicon-based material during charging and discharging, effectively alleviating the problem of increased volume of the secondary battery caused by the swelling of the silicon-based material. Further, through adjustment of a preparation process, the silicon-carbon composite material satisfies $V_A/V_B \geq 1.40$, which can effectively improve the cycling performance and the first-cycle charge-discharge efficiency of the silicon-carbon composite material.

In some embodiments, $1.42 \leq V_A/V_B \leq 1.90$.

In some embodiments, $1.50 \leq V_A/V_B \leq 1.70$.

In some embodiments, a grain size of the silicon-based material is less than or equal to 6 nm.

In some embodiments, a pore diameter of the pore structure is 0.5 nm-8 nm.

In some embodiments, the pore structure includes micropores with a pore diameter greater than or equal to 0.5 nm and less than 2 nm and mesopores with a pore diameter of 2 nm-8 nm.

In some embodiments, a quantity proportion of the micropores in the pore structure is 60%-90%.

In some embodiments, a specific surface area of the silicon-carbon composite material is 2 $m^2/g$-10 $m^2/g$.

In some embodiments, the silicon-carbon composite material has at least one of the following features:

(1) the silicon-based material includes elemental silicon;

(2) a shape of the silicon-based material includes one or more of a spherical shape, a quasi-spherical shape, a flaky shape, and a linear shape;
(3) a specific surface area of the carbon matrix is 1000 $m^2/g$-2000 $m^2/g$;
(4) a mass proportion of the silicon-based material in the silicon-carbon composite material is 35%-60%;
(5) a particle size by volume $D_v50$ of the silicon-carbon composite material is 3 μm-15 μm;
(6) a particle size by volume $D_v90$ of the silicon-carbon composite material is less than or equal to 50 μm;
(7) the silicon-carbon composite material satisfies: $1 \leq (D_v90-D_v10)/D_v50 \leq 3$;
(8) a tap density of the silicon-carbon composite material is 0.8 $g/cm^3$-1.2 $g/cm^3$; and
(9) a powder resistivity of the silicon-carbon composite material at 16 MPa is less than or equal to 5 Ω·m.

In some embodiments, at least part of an outer surface of the silicon-carbon composite material further includes a carbon coating layer.

In some embodiments, the carbon coating layer has at least one of the following features:

(1) a material of the carbon coating layer includes amorphous carbon; and
(2) a thickness of the carbon coating layer is 50 nm-200 nm.

A second aspect of this application provides a preparation method of a silicon-carbon composite material. The preparation method includes the following steps:

preparing a carbon substrate;
performing a pore formation treatment on the carbon substrate to obtain a carbon matrix A having a pore structure;
performing a pore diameter adjustment treatment on the carbon matrix A having a pore structure to obtain a carbon matrix B having a pore structure; and
depositing a silicon-based material in the pore structure of the carbon matrix B having a pore structure to prepare the silicon-carbon composite material, where a button battery is used to charge and discharge the silicon-carbon composite material, a curve graph of a relationship between a differential value dQ/dV obtained by differentiating a voltage V of a charge-discharge curve of the button battery with respect to a charge-discharge capacity Q and the voltage V is plotted, a maximum value of the differential value dQ/dV within a range of 0.26 V-0.35 V is denoted as $V_A$, a maximum value of the differential value dQ/dV within a range of 0.42 V-0.52 V is denoted as $V_B$, and the silicon-carbon composite material satisfies: $V_A/V_B \geq 1.40$.

In some embodiments, the step of preparing the carbon substrate includes: performing a first sintering treatment on a carbon material precursor to prepare the carbon substrate.

In some embodiments, the preparation of the carbon substrate satisfies at least one of the following conditions:

(1) a temperature of the first sintering treatment is 400°C-800°C;
(2) a time of the first sintering treatment is 1 h-12 h;
(3) an atmosphere of the first sintering treatment includes an inert gas;
(4) the inert gas includes one or more of nitrogen and argon; and
(5) the carbon material precursor includes one or more of a resin carbon material and a biomass carbon material.

In some embodiments, the step of the pore formation treatment includes: performing alkaline etching on the carbon substrate using an alkaline substance.

In some embodiments, the pore formation treatment satisfies at least one of the following conditions:

(1) the alkaline substance includes one or more of potassium hydroxide and sodium hydroxide; and
(2) a mass ratio of the alkaline substance to the carbon substrate is (2-6):1.

In some embodiments, the step of the pore diameter adjustment treatment includes: placing the carbon matrix A having a pore structure in a mixed gas containing a first carbon source and an inert gas to perform a first vapor deposition.

In some embodiments, a temperature of the first vapor deposition is 800°C-1000°C.

In some embodiments, the temperature of the first vapor deposition is 850°C-950°C.

In some embodiments, a time of the first vapor deposition is 1 h-4 h.

In some embodiments, a volume ratio of the first carbon source to the inert gas is (2-5):10.

In some embodiments, the first vapor deposition further includes at least one of the following conditions:

(1) the first carbon source includes one or more of methane, ethylene, and acetylene; and

(2) the inert gas includes one or more of nitrogen and argon.

In some embodiments, the carbon matrix B having a pore structure is placed in a mixed gas containing a silicon source and an inert gas to perform a second vapor deposition.
In some embodiments, a temperature of the second vapor deposition is 450°C-650°C.
In some embodiments, the temperature of the second vapor deposition is 500°C-600°C.
In some embodiments, a time of the second vapor deposition is 4 h-8 h.
In some embodiments, the second vapor deposition includes at least one of the following conditions:

(1) a volume proportion of the silicon source in the mixed gas is 10%-40%; and
(2) a volume proportion of the inert gas in the mixed gas is 60%-90%.

In some embodiments, the second vapor deposition further includes at least one of the following conditions:

(1) a positive difference between a pressure of the second vapor deposition and atmospheric pressure is 0.2 KPa-0.6 KPa;
(2) the silicon source includes one or more of monosilane, disilane, and trisilane; and
(3) the inert gas includes one or more of nitrogen and argon.

In some embodiments, before the step of the pore diameter adjustment treatment, the preparation method further includes:
removing, using an acidic substance, the alkaline substance remaining on the carbon substrate after the pore formation treatment.
In some embodiments, the preparation method further includes:
placing the silicon-carbon composite material in a mixed gas containing a second carbon source and an inert gas to perform a third vapor deposition to form a carbon coating layer on at least part of an outer surface of the silicon-carbon composite material.
In some embodiments, the third vapor deposition satisfies at least one of the following conditions:

(1) the second carbon source includes one or more of methane, ethylene, and acetylene;
(2) the inert gas includes one or more of nitrogen and argon;
(3) a volume proportion of the second carbon source in the mixed gas is 5%-20%;
(4) a temperature of the third vapor deposition is 500°C-700°C; and
(5) a time of the third vapor deposition is 1 h-6 h.

A third aspect of this application provides a secondary battery including a negative electrode plate, where the negative electrode plate includes the silicon-carbon composite material according to the first aspect of this application or a silicon-carbon composite material prepared by the method according to the second aspect of this application.
A fourth aspect of this application provides an electric apparatus including the secondary battery according to the third aspect of this application.

## BRIEF DESCRIPTION OF DRAWINGS

In order to more clearly illustrate the technical solutions of this application, the drawings used in this application will be briefly described below. Apparently, the drawings described below are only some embodiments of this application, and for persons of ordinary skill in the art, other drawings can be obtained according to the drawings without creative efforts.

FIG. 1 is a schematic diagram of a secondary battery according to an embodiment of this application.
FIG. 2 is an exploded view of the secondary battery according to the embodiment of this application shown in FIG. 1.
FIG. 3 is a schematic diagram of an electric apparatus using the secondary battery as a power source according to an embodiment of this application.
FIG. 4 is a cross-sectional SEM image of a negative electrode plate prepared using a silicon-carbon composite material according to an embodiment of this application.
FIG. 5 is a curve graph of a relationship between a differential value dQ/dV and a working electrode potential V of a battery cell prepared using a silicon-carbon composite material in Example 3.

Description of reference signs:

1. secondary battery; 11. housing; 12. electrode assembly; 13. cover plate; 2. electric apparatus; 411. carbon matrix; and 412. carbon coating layer.

## DESCRIPTION OF EMBODIMENTS

In order to facilitate understanding of this application, this application will be described more fully below with reference to the relevant drawings. Preferred embodiments of this application are given in the drawings. However, this application can be implemented in many different forms and is not limited to the embodiments described herein. On the contrary, the purpose of providing these embodiments is to make the understanding of the disclosure of this application more thorough and comprehensive.

Unless otherwise defined, all technical and scientific terms used herein have the same meaning as commonly understood by persons skilled in the technical field to which this application belongs. The terms used herein in the specification of this application are only for the purpose of describing specific embodiments and are not intended to limit this application.

In this application, technical features described in an open form include closed technical solutions composed of the listed features, and also include open technical solutions including the listed features.

In this application, for numerical intervals, if not otherwise specified, the above numerical intervals are considered continuous and include the minimum and maximum values of the range, as well as every value between such minimum and maximum values. Further, when the range refers to integers, every integer between the minimum and maximum values of the range is included. In addition, when multiple ranges are provided to describe features or characteristics, the ranges can be combined. In other words, unless otherwise indicated, all ranges disclosed herein are to be understood to include any and all subranges subsumed therein.

In this application, for units involving data ranges, if the unit is only indicated after the right endpoint, it means that the units of the left endpoint and the right endpoint are the same. For example, 10-1000 nm means that the units of the left endpoint "10" and the right endpoint "1000" are both nm (nanometers).

In this application, "a plurality of", "multiple", "a plurality of times", and the like, if not otherwise limited, refer to more than 2 or equal to 2 in quantity. For example, "multiple" means greater than or equal to two. This specification only specifically discloses some numerical ranges. However, any lower limit can be combined with any upper limit to form an unspecified range; and any lower limit can be combined with other lower limits to form an unspecified range, and similarly any upper limit can be combined with any other upper limit to form an unspecified range. In addition, each individually disclosed point or single numerical value itself can serve as a lower limit or upper limit combined with any other point or single numerical value or with other lower limits or upper limits to form an unspecified range.

The "range" disclosed in this application is defined in the form of lower and upper limits, and a given range is defined by selecting a lower limit and an upper limit, where the selected lower and upper limits define the boundaries of the particular range. Ranges defined in this manner may be inclusive or exclusive of endpoints.

In this application, temperature parameters, if not otherwise limited, allow for constant temperature treatment or treatment within a certain temperature interval. The constant temperature treatment allows the temperature to fluctuate within the precision range controlled by the instrument.

If not otherwise specified, all embodiments and optional embodiments of this application can be combined with each other to form new technical solutions. If not otherwise specified, all technical features and optional technical features of this application can be combined with each other to form new technical solutions.

If not otherwise specified, all steps of this application can be performed sequentially or randomly, preferably sequentially.

Silicon-containing materials are widely used in secondary batteries. However, silicon has the characteristic of high swelling and poor conductivity; therefore, in related technologies, secondary batteries using silicon-containing materials have increased energy densities but suffer from poor swelling resistance and cycling performance.

Based on the above problems, this application provides a silicon-carbon composite material, where the silicon-carbon composite material includes a carbon matrix having a pore structure and a silicon-based material distributed in the pore structure. The pore structure can provide space for the swelling of the silicon-based material, alleviating the problems of increased volumes of secondary batteries caused by the swelling of the silicon-based material; and in order to explore the cycling performance of the silicon-carbon composite material, a silicon-carbon composite material with $V_A/V_B \geq 1.4$ is selected, so that the cycling performance of the silicon-carbon composite material can be significantly improved.

A first aspect of this application provides a silicon-carbon composite material including a carbon matrix and a silicon-based material, where the carbon matrix has a pore structure, and the silicon-based material is distributed in the pore structure of the carbon matrix; when a button battery is configured to perform charging and discharging, a curve graph of a relationship between a differential value dQ/dV obtained by differentiating a voltage V of a charge-discharge curve of

the button battery with respect to a charge-discharge capacity Q and the voltage V is plotted, a maximum value of the differential value dQ/dV within a range of 0.26 volts (V)-0.35 volts is denoted as $V_A$, a maximum value of the differential value dQ/dV within a range of 0.42 volts-0.52 volts is denoted as $V_B$, and the silicon-carbon composite material satisfies: $V_A/V_B \geq 1.40$.

The carbon matrix of this application refers to a carbon-based material having a pore structure on its outer surface and/or inside, and the quantity of pore structures contained in the carbon matrix may be one or more. The silicon-carbon composite material includes the silicon-based material distributed in the pore structure of the carbon matrix, and may further include a silicon-based material distributed on a surface of a scaffold of the carbon matrix.

It should be noted that when a curve graph of a relationship between a differential value dQ/dV obtained by differentiating a working electrode voltage V with respect to a charge-discharge capacity Q and the working electrode voltage V is plotted, a curve of a voltage V and a delithiation capacity Q can be obtained according to a preparation method and test method of the button battery, and then the curve is differentiated, where the button battery includes a working electrode using the silicon-carbon composite material of this application as an active material, a counter electrode composed of metallic lithium, and a lithium-ion electrolyte, with a voltage of 0.005 V-2.0 V and a current of 0.1C.

It can be understood that the silicon-carbon composite material of this application includes a carbon matrix having a pore structure and a silicon-based material distributed in the pore structure. The carbon matrix can improve the conductivity of the silicon-based material and can also serve as a buffer medium for the volume swelling of the silicon-based material during charging and discharging, effectively alleviating the problems of increased volumes of secondary batteries caused by the swelling of the silicon-based material. Further, through adjustment of a preparation process, the silicon-carbon composite material satisfies $V_A/V_B \geq 1.40$, which can effectively improve the cycling performance and the first-cycle charge-discharge efficiency of the silicon-carbon composite material.

In some embodiments, $1.40 \leq V_A/V_B \leq 1.90$. For example, $V_A/V_B$ may be but is not limited to 1.40, 1.41, 1.42, 1.43, 1.44, 1.45, 1.46, 1.47, 1.48, 1.49, 1.5, 1.51, 1.52, 1.53, 1.54, 1.55, 1.56, 1.57, 1.58, 1.59, 1.6, 1.61, 1.62, 1.63, 1.64, 1.65, 1.66, 1.67, 1.68, 1.69, 1.7, 1.71, 1.72, 1.73, 1.74, 1.75, 1.76, 1.77, 1.78, 1.79, 1.8, 1.81, 1.82, 1.83, 1.84, 1.85, 1.86, 1.87, 1.88, 1.89, 1.9, or a range defined by any two of the above values.

As an example, the ratio $V_A/V_B$ may be 1.40-1.88, 1.40-1.85, 1.40-1.73, 1.40-1.68, 1.40-1.60, 1.42-1.90, 1.45-1.90, 1.45-1.85, 1.45-1.8, 1.45-1.75, 1.45-1.7, 1.45-1.65, 1.65-1.9, 1.65-1.85, 1.65-1.8, 1.5-1.7, 1.51-1.69, 1.52-1.68, 1.53-1.67, 1.54-1.66, 1.55-1.65, 1.56-1.64, 1.57-1.63, 1.58-1.62, or 1.59-1.61, without specific limitation.

In some optional embodiments, $1.50 \leq V_A/V_B \leq 1.70$.

In some embodiments, a grain size of the silicon-based material is less than or equal to 6 nm. When the grain size of the silicon-based material is greater than the above range, the structure of the silicon-carbon composite material may collapse during cycling due to the excessively large grain size of the silicon-based material. As an example, the grain size of the silicon-based material may be but is not limited to 0.01 nm, 0.05 nm, 0.1 nm, 0.5 nm, 1 nm, 1.5 nm, 2 nm, 2.5 nm, 3 nm, 3.5 nm, 4 nm, 4.5 nm, 5 nm, 5.5 nm, 6 nm, or a range defined by any two of the above values. Optionally, the grain size of the silicon-based material is 1 nm-4 nm.

As an example, the grain size of the silicon-based material mentioned above can be calculated using an X-ray diffraction pattern or characterized by a transmission electron microscope to obtain the grain size of the silicon-based material.

In some embodiments, the silicon-based material includes elemental silicon.

In some embodiments, a shape of the silicon-based material includes one or more of a spherical shape, a quasi-spherical shape, a flaky shape, and a linear shape.

In some embodiments, a pore diameter of the pore structure of the carbon matrix is 0.5 nm-8 nm. When the pore diameter of the pore structure of the carbon matrix is within the above range, the silicon-based material deposited in the pore structure may have a relatively uniform size, reducing the probability of deposition of a large-sized silicon-based material. As an example, the pore diameter of the pore structure of the carbon matrix may be but is not limited to 0.5 nm, 1 nm, 2 nm, 2.5 nm, 3 nm, 3.5 nm, 4 nm, 4.5 nm, 5 nm, 5.5 nm, 6 nm, 6.5 nm, 7 nm, 7.5 nm, 8 nm, or a range defined by any two of the above values. Optionally, the pore diameter of the pore structure of the carbon matrix is 0.5 nm-6 nm.

It should be noted that when the carbon matrix has only a single pore structure, the pore diameter of the pore structure is a pore diameter of the single pore structure. When the carbon matrix has multiple pore structures, the pore diameter of the pore structure refers to an average pore diameter of the pore structures.

In some embodiments, the pore structure of the carbon matrix includes micropores with a pore diameter greater than or equal to 0.5 nm and less than 2 nm and mesopores with a pore diameter of 2 nm-8 nm. Optionally, the pore structure of the carbon matrix includes micropores with a pore diameter greater than or equal to 0.5 nm and less than 2 nm and mesopores with a pore diameter of 2 nm-6 nm.

In some embodiments, a quantity proportion of the micropores in the pore structure is 60%-90%. For example, it may be but is not limited to 60%, 63%, 65%, 68%, 70%, 72%, 75%, 78%, 80%, 83%, 85%, 88%, 90%, or a range defined by any two of the above values. When the quantity proportion of the micropores in the pore structure is within the above range, the probability of deposition of the large-sized silicon-based material can be further reduced, which is more conducive to

adjusting the value of $V_A/V_B$. Optionally, the quantity proportion of the micropores in the pore structure is 70%-80%.

As a possible embodiment, a specific surface area of the carbon matrix is 1000 $m^2/g$-2000 $m^2/g$. When the specific surface area of the carbon matrix is lower than the above range, silicon is easily deposited on the surface of the carbon matrix. When the specific surface area of the carbon matrix is higher than the above range, the silicon deposition amount is easily excessive, resulting in excessive volume swelling of silicon during cycling and collapse of the carbon matrix. As an example, the specific surface area of the carbon matrix may be but is not limited to 1000 $m^2/g$, 1100 $m^2/g$, 1200 $m^2/g$, 1300 $m^2/g$, 1400 $m^2/g$, 1500 $m^2/g$, 1600 $m^2/g$, 1700 $m^2/g$, 1800 $m^2/g$, 1900 $m^2/g$, 2000 $m^2/g$, or a range defined by any two of the above values. Optionally, the specific surface area of the carbon matrix is 1300 $m^2/g$-2000 $m^2/g$. In some embodiments, a mass proportion of the silicon-based material in the silicon-carbon composite material is 35%-60%. When the mass proportion of the silicon-based material in the silicon-carbon composite material is lower than the above range, the capacity and first-cycle efficiency of the silicon-carbon composite material may be excessively low. When the mass proportion of the silicon-based material in the silicon-carbon composite material is higher than the above range, the cycling performance of the silicon-carbon composite material may be deteriorated. As an example, the mass proportion of the silicon-based material in the silicon-carbon composite material may be but is not limited to 35%, 36%, 37%, 38%, 39%, 40%, 41%, 42%, 43%, 44%, 45%, 46%, 47%, 48%, 49%, 50%, 51%, 52%, 53%, 54%, 55%, 56%, 57%, 58%, 59%, 60%, or a range defined by any two of the above values. Optionally, the mass proportion of the silicon-based material in the silicon-carbon composite material is 40%-55%.

As an example, the mass proportion of the silicon-based material in the silicon-carbon composite material can be measured using ICP emission spectrometry.

In some embodiments, a particle size by volume $D_v50$ of the silicon-carbon composite material is 3 μm-15 μm. When the particle size by volume $D_v50$ of the silicon-carbon composite material is higher than the above range, the kinetic performance of the secondary battery is easily deteriorated. When the particle size by volume $D_v50$ of the silicon-carbon composite material is lower than the above range, a problem of uneven deposition of the silicon-based material in the carbon matrix may be caused. As an example, the particle size by volume $D_v50$ of the silicon-carbon composite material may be but is not limited to 3 μm, 4 μm, 5 μm, 6 μm, 7 μm, 8 μm, 9 μm, 10 μm, 11 μm, 12 μm, 13 μm, 14 μm, 15 μm, 16 μm, 17 μm, 18 μm, 19 μm, 20 μm, or a range defined by any two of the above values. Optionally, the particle size by volume $D_v50$ of the silicon-carbon composite material is 5 μm-13 μm.

In some embodiments, a particle size by volume $D_v90$ of the silicon-carbon composite material is less than or equal to 50 μm. When the particle size by volume $D_v90$ of the silicon-carbon composite material is higher than the above range, a separator may be pierced by a negative electrode reagent bottle. As an example, the particle size by volume $D_v90$ of the silicon-carbon composite material may be but is not limited to 5 μm, 10 μm, 15 μm, 20 μm, 25 μm, 30 μm, 35 μm, 40 μm, 45 μm, 50 μm, or a range defined by any two of the above values. Optionally, the particle size by volume $D_v90$ of the silicon-carbon composite material is 20 μm-40 μm.

In some embodiments, the silicon-carbon composite material satisfies: $1 \leq (D_v90-D_v10)/D_v50 \leq 3$. When the silicon-carbon composite material satisfies the above condition, the increase in a compacted density of a negative electrode plate is facilitated. As an example, $(D_v90-D_v10)/D_v50$ may be but is not limited to 1, 1.1, 1.2, 1.3, 1.4, 1.5, 1.6, 1.7, 1.8, 1.9, 2, 2.1, 2.2, 2.3, 2.4, 2.5, 2.6, 2.7, 2.8, 2.9, 3, or a range defined by any two of the above values. Optionally, $1 \leq (D_v90-D_v10)/D_v50 \leq 2$.

$D_v10$, $D_v50$, and $D_v90$ of the material have well-known meanings in the art and can be tested using methods known in the art. For example, $D_v10$, $D_v50$, and $D_v90$ of the material can be measured using a laser particle size analyzer (such as Malvern Master Size 3000) with reference to the standard GB/T 19077-2016.

Physical definitions of $D_v10$, $D_v50$, and $D_v90$ are described below.

$D_v10$: A corresponding particle size when the cumulative volume distribution percentage of the material reaches 10%.

$D_v50$: A corresponding particle size when the cumulative volume distribution percentage of the material reaches 50%.

$D_v90$: A corresponding particle size when the cumulative volume distribution percentage of the material reaches 90%.

As a possible embodiment, a specific surface area of the silicon-carbon composite material is 2 $m^2/g$-20 $m^2/g$. When the specific surface area of the silicon-carbon composite material is higher than the above range, the first-cycle efficiency of the secondary battery may be reduced. As an example, the specific surface area of the silicon-carbon composite material may be but is not limited to 2 $m^2/g$, 3 $m^2/g$, 4 $m^2/g$, 5 $m^2/g$, 6 $m^2/g$, 7 $m^2/g$, 8 $m^2/g$, 9 $m^2/g$, 10 $m^2/g$, 11 $m^2/g$, 12 $m^2/g$, 13 $m^2/g$, 14 $m^2/g$, 15 $m^2/g$, 16 $m^2/g$, 17 $m^2/g$, 18 $m^2/g$, 19 $m^2/g$, 20 $m^2/g$, or a range defined by any two of the above values. Optionally, the specific surface area of the silicon-carbon composite material is 2 $m^2/g$-6 $m^2/g$.

As an example, the pore diameter of the pore structure of the carbon matrix and the specific surface area of the silicon-carbon composite material mentioned above have well-known meanings in the art and can be tested using methods known in the art. For example, they can be tested using a nitrogen adsorption specific surface area analysis test method with reference to GB/T 19587-2017, and calculated using a BET (Brunauer Emmett Teller) method, where the

nitrogen adsorption specific surface area analysis test can be performed using a Tri-Star 3020 specific surface area and pore size analyzer from Micromeritics, USA.

In some possible embodiments, a tap density of the silicon-carbon composite material is 0.8 g/cm$^3$-1.2 g/cm$^3$. As an example, the tap density of the silicon-carbon composite material may be but is not limited to 0.8 g/cm$^3$, 0.83 g/cm$^3$, 0.85 g/cm$^3$, 0.87 g/cm$^3$, 0.9 g/cm$^3$, 0.92 g/cm$^3$, 0.95 g/cm$^3$, 0.98 g/cm$^3$, 1 g/cm$^3$, 1.02 g/cm$^3$, 1.05 g/cm$^3$, 1.08 g/cm$^3$, 1.1 g/cm$^3$, 1.12 g/cm$^3$, 1.15 g/cm$^3$, 1.18 g/cm$^3$, 1.2 g/cm$^3$, or a range defined by any two of the above values. Optionally, the tap density of the silicon-carbon composite material is 0.85 g/cm$^3$-1 g/cm$^3$.

It should be noted that the tap density of the silicon-carbon composite material mentioned above refers to a mass per unit volume measured after silicon-carbon composite material powder in a container is tapped under specified conditions.

The tap density of the negative electrode active material has a well-known meaning in the art and can be tested using methods known in the art. For example, it can be measured using a powder tap density tester with reference to the standard GB/T 5162-2006. For example, an FZS4-4B tap density meter from Beijing Iron and Steel Research Institute is used, with test parameters are as follows: a vibration frequency is 250±15 times/min, an amplitude is 3±0.2 mm, vibration times are 5000 times, a measuring cylinder is a 25 mL measuring cylinder.

In some embodiments, a powder resistivity of the silicon-carbon composite material at 16 MPa is less than or equal to 5 Ω·m. The silicon-carbon composite material has excellent conductivity, which helps to improve the kinetic performance of the battery. Optionally, the powder resistivity of the silicon-carbon composite material at 16 MPa is less than or equal to 2 Ω·m.

As an example, the powder resistivity of the silicon-carbon composite material at 16 MPa mentioned above can be measured using the following method: placing an appropriate amount of a sample under test in a feeding cup of a resistivity tester, applying pressure, manually collecting data, and recording powder resistivity test results at different pressure points, with a test pressure of 16 MPa.

In some embodiments, a first charge-discharge cycle efficiency of the silicon-carbon composite material is greater than or equal to 90%. Optionally, the first charge-discharge cycle efficiency of the silicon-carbon composite material is 92%-95%.

As an example, the first charge-discharge cycle efficiency of the silicon-carbon composite material mentioned above can be measured using the following method:

A negative electrode plate prepared from the sample under test serves as a working electrode, metallic lithium serves as a counter electrode, and a button battery is constructed with an electrolyte containing a lithium-ion conductive substance. A test process is as follows: after left standing for 60 min, the button battery is discharged at a constant current of 0.05C to 5 mV, discharged at 50 μA to 5 mV, left standing for 10 min, and charged at 0.1C to 2.0 V. A delithiation capacity at 2.0 V represents a capacity of the sample under test, and a corresponding first-cycle efficiency = delithiation capacity at 2.0 V / lithiation capacity.

In some embodiments, at least part of an outer surface of the silicon-carbon composite material further includes a carbon coating layer. With the carbon coating layer provided, the contact between the silicon-based material and the electrolyte can be reduced, and battery side reactions can be decreased, thereby improving the cycling performance of the battery.

It should be noted that the carbon coating layer may be a continuous complete coating layer or an incomplete coating layer; where "complete" means that a substance on an inner side of the carbon coating layer is completely coated with the carbon coating layer, and the carbon coating layer completely isolates the substance on the inner side of the carbon coating layer from the outer side. "Incomplete" means that the substance inside the carbon coating layer is not completely coated with the carbon coating layer, and at least part of the substance on the inner side of the carbon coating layer may be in contact with the outer side of the carbon coating layer. Preferably, the carbon coating layer is a continuous complete coating layer.

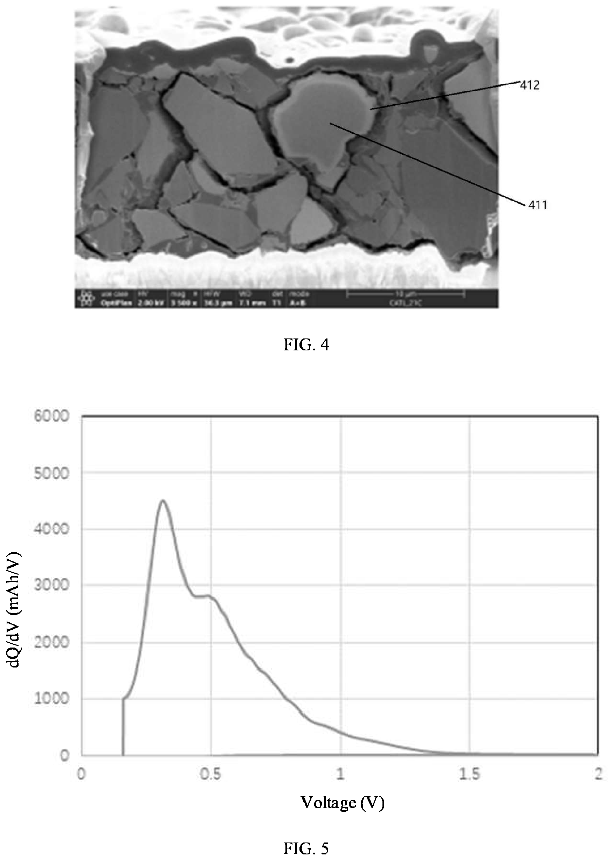

As an example, a cross-sectional SEM image of a negative electrode plate prepared using the silicon-carbon composite material of this application is shown in FIG. 4, where an outer side of the carbon matrix 411 is coated with a uniform carbon coating layer 412, which can prevent exposure of the carbon matrix, thereby reducing the reaction between the silicon-based material and the electrolyte.

In some embodiments, a material of the carbon coating layer includes amorphous carbon; and the amorphous carbon can play a role in fast charging ion rings, improve the kinetic performance of the silicon-carbon composite material, and reduce the contact between the silicon-based material and the electrolyte.

In some embodiments, a thickness of the carbon coating layer is 50 nm-200 nm. When the thickness of the carbon coating layer is lower than the above range, the exposure of the silicon-based material may be caused, affecting the processing performance. When the thickness of the carbon coating layer is higher than the above range, the capacity of the secondary battery may decrease. As an example, the thickness of the carbon coating layer may be but is not limited to 50 nm, 60 nm, 70 nm, 80 nm, 90 nm, 100 nm, 110 nm, 120 nm, 130 nm, 140 nm, 150 nm, 160 nm, 170 nm, 180 nm, 190 nm, 200 nm, or a range defined by any two of the above values.

As an example, the thickness of the carbon coating layer mentioned above can be measured using a transmission electron microscope.

A second aspect of this application provides a preparation method of a silicon-carbon composite material. The preparation method includes the following steps: preparing a carbon substrate; performing a pore formation treatment on the carbon substrate to obtain a carbon matrix A having a pore structure; performing a pore diameter adjustment treatment on the carbon matrix A having a pore structure to obtain a carbon matrix B having a pore structure; and depositing a silicon-based material in the pore structure of the carbon matrix B having a pore structure to prepare a silicon-carbon composite material; where a button battery is used to charge and discharge the silicon-carbon composite material, a curve graph of a relationship between a differential value dQ/dV obtained by differentiating a voltage V of a charge-discharge curve of the button battery with respect to a charge-discharge capacity Q and the voltage V is plotted, a maximum value of the differential value dQ/dV within a range of 0.26 V-0.35 V is denoted as $V_A$, a maximum value of the differential value dQ/dV within a range of 0.42 V-0.52 V is denoted as $V_B$, and the silicon-carbon composite material satisfies: $V_A/V_B \geq 1.40$.

In some embodiments, the step of preparing the carbon substrate includes: performing a first sintering treatment on a carbon material precursor to prepare the carbon substrate.

As a possible embodiment, a temperature of the first sintering treatment is 400°C-800°C. For example, it may be but is not limited to 400°C, 430°C, 450°C, 480°C, 500°C, 530°C, 550°C, 570°C, 600°C, 630°C, 650°C, 680°C, 700°C, 730°C, 750°C, 770°C, 800°C, or a range defined by any two of the above values. A time of the first sintering treatment is 1 h-12 h. For example, it may be but is not limited to 1 h, 2 h, 3 h, 4 h, 5 h, 6 h, 7 h, 8 h, 9 h, 10 h, 11 h, 12 h, or a range defined by any two of the above values. An atmosphere of the first sintering treatment includes an inert gas. Optionally, the inert gas includes one or more of nitrogen and argon.

As a possible embodiment, the carbon material precursor includes one or more of a resin carbon material and a biomass carbon material.

Optionally, the resin carbon material includes one or more of phenolic resin, epoxy resin, urea-formaldehyde resin, and furan resin.

Optionally, the biomass carbon material includes one or more of coconut shell, lignin, bamboo powder, and starch.

It should be noted that bamboo powder refers to powder prepared from bamboo as a raw material.

In some embodiments, the step of the pore formation treatment includes: performing alkaline etching on the carbon substrate using an alkaline substance.

In some optional embodiments, the alkaline substance includes one or more of potassium hydroxide and sodium hydroxide.

In some optional embodiments, a mass ratio of the alkaline substance to the carbon substrate is (2-6):1. As an example, the mass ratio of the alkaline substance to the carbon substrate may be but is not limited to 2:1, 2.5:1, 3:1, 3.5:1, 4:1, 4.5:1, 5:1, 5.5:1, 6:1, or a range defined by any two of the above ratios.

As a possible embodiment, before the step of the pore diameter adjustment treatment, the preparation method further includes: removing, using an acidic substance, the alkaline substance remaining on the carbon substrate after the pore formation treatment. Optionally, the acidic substance includes hydrochloric acid.

In some embodiments, the step of the pore diameter adjustment treatment includes: placing the carbon matrix A having a pore structure in a mixed gas containing a first carbon source and an inert gas to perform a first vapor deposition.

The first carbon source is deposited using a vapor deposition method to adjust the pore diameter of the carbon substrate, and a volume ratio of the first carbon source to the inert gas during vapor deposition is of (2-5):10, so that a pore diameter of macropores of the carbon substrate can be reduced, thereby avoiding the deposition of the large-sized silicon-based material.

In some optional embodiments, a temperature of the first vapor deposition is 800°C-1000°C. For example, it may be but is not limited to 800°C, 810°C, 820°C, 830°C, 840°C, 850°C, 860°C, 870°C, 880°C, 890°C, 900°C, 910°C, 920°C, 930°C, 940°C, 950°C, 960°C, 970°C, 980°C, 990°C, 1000°C, or a range defined by any two of the above values. The temperature of the first vapor deposition falling within the above range facilitates decomposition of the carbon source and is conducive to pore diameter adjustment. As an example, the temperature of the first vapor deposition may be 810°C-990°C, 820°C-980°C, 830°C-970°C, 840°C-960°C, 850°C-950°C, 860°C-940°C, 870°C-930°C, or 880°C-920°C, without specific limitation. Optionally, the temperature of the first vapor deposition is 850°C-950°C.

In some optional embodiments, a time of the first vapor deposition is 1 h-4 h. For example, it may be but is not limited to 1 h, 1.2 h, 1.5 h, 1.8 h, 2 h, 2.3 h, 2.5 h, 2.8 h, 3 h, 3.3 h, 3.5 h, 3.7 h, 4 h, or a range defined by any two of the above values. The time of the first vapor deposition falling within the above range is conducive to adjusting the pore diameter to an appropriate size and controlling the proportion of micropores and mesopores in the pore structure. Optionally, the time of the first vapor deposition is 1.5 h-3 h.

In some optional embodiments, a volume ratio of the first carbon source to the inert gas is (2-5):10. The volume ratio of the first carbon source to the inert gas falling within the above range is conducive to adjusting the pore diameter of the pore structure of the carbon matrix to be more uniform. As an example, the volume ratio of the first carbon source to the

inert gas may be but is not limited to 2:10, 2.3:10, 2.5:10, 2.8:10, 3:10, 3.2:10, 3.5:10, 3.8:10, 4:10, 4.3:10, 4.5:10, 4.8:10, 5:10, or a range defined by any two of the above ratios. Optionally, the volume ratio of the first carbon source to the inert gas is (2.5-4):10.

It should be noted that the temperature and time of the first vapor deposition and the volume ratio of the first carbon source to the inert gas all affect the pore diameter size of the pore structure, and the pore diameter size of the pore structure affects the value of $V_A/V_B$. Adjusting the temperature and time of the first vapor deposition and the volume ratio of the first carbon source to the inert gas is conducive to further adjusting the value of $V_A/V_B$ to an appropriate range. Specifically, when the temperature of the first vapor deposition is low, the value of $V_A/V_B$ is typically small; when the time of the first vapor deposition is short, the value of $V_A/V_B$ is typically small; and when the volume ratio of the first carbon source to the inert gas is small, the value of $V_A/V_B$ is typically small.

In some optional embodiments, the first carbon source includes one or more of methane, ethylene, and acetylene.

In some optional embodiments, the inert gas includes one or more of nitrogen and argon.

In some embodiments, the carbon matrix B having a pore structure is placed in a mixed gas containing a silicon source and an inert gas to perform a second vapor deposition to deposit the silicon-based material in the pore structure of the carbon matrix. Using the vapor deposition method to deposit the silicon-based material in the pore structure can increase the proportion of the silicon-based material embedded in the pore structure.

In some optional embodiments, a temperature of the second vapor deposition is 450°C-650°C. For example, it may be but is not limited to 450°C, 460°C, 470°C, 480°C, 490°C, 500°C, 510°C, 520°C, 530°C, 540°C, 550°C, 560°C, 570°C, 580°C, 590°C, 600°C, 610°C, 620°C, 630°C, 640°C, 650°C, or a range defined by any two of the above values. The temperature of the second vapor deposition falling within the above range is conducive to adjusting the mass proportion of the silicon-based material in the silicon-carbon composite material to fall within an appropriate range. If the temperature of the second vapor deposition is excessively high, the silicon-based material is prone to crystallization, which affects the cycling performance of the battery. If the temperature of the second vapor deposition is excessively low, the decomposition efficiency of the silicon source decreases. As an example, the temperature of the second vapor deposition may be 460°C-640°C, 470°C-630°C, 480°C-620°C, 490°C-610°C, 500°C-600°C, 510°C-590°C, 520°C-580°C, or 530°C-570°C, without specific limitation. Optionally, the temperature of the second vapor deposition is 500°C-600°C; and more optionally, the temperature of the second vapor deposition is 520°C-580°C.

In some optional embodiments, a time of the second vapor deposition is 4 h-8 h. For example, it may be but is not limited to 4 h, 4.2 h, 4.5 h, 4.8 h, 5 h, 5.2 h, 5.5 h, 5.8 h, 6 h, 6.3 h, 6.5 h, 6.7 h, 7 h, 7.3 h, 7.5 h, 7.7 h, 8 h, or a range defined by any two of the above values. The time of the second vapor deposition falling within the above range is conducive to adjusting the mass proportion of the silicon-based material in the silicon-carbon composite material. If the time of the second vapor deposition is excessively long, the silicon-based material is prone to accumulation on the surface of the carbon matrix. If the time of the second vapor deposition is excessively short, the amount of the silicon-based material deposited is low, failing to reach a capacity design value. As an example, the time of the second vapor deposition may be 4.2 h-7.8 h, 4.5 h-7.5 h, 4.8 h-7.3 h, 5 h-7 h, 5.2 h-6.8 h, 5.5 h-6.5 h, 5.8 h-6.3 h, or the like, without specific limitation. Optionally, the time of the second vapor deposition is 4.5 h-7 h; and more optionally, the time of the second vapor deposition is 5 h-6 h.

In some optional embodiments, a volume proportion of the silicon source in the mixed gas is 10%-40%, and a volume proportion of the inert gas in the mixed gas is 60%-90%. Controlling the volume proportion of the silicon source in the mixed gas within the above range is conducive to depositing a silicon-based material with a relatively uniform size. For example, the volume proportion of the silicon source in the mixed gas may be but is not limited to 10%, 15%, 20%, 25%, 30%, 35%, 40%, or a range defined by any two of the above values. Accordingly, the volume proportion of the inert gas in the mixed gas may be but is not limited to 90%, 85%, 80%, 75%, 70%, 65%, 60%, or a range defined by any two of the above values.

It should be noted that the temperature and time of the second vapor deposition and the volume ratio of the silicon source to the inert gas all affect the mass proportion of the silicon-based material in the silicon-carbon composite material, and the mass proportion of the silicon-based material in the silicon-carbon composite material affects the value of $V_A/V_B$. Adjusting the temperature and time of the second vapor deposition and the volume ratio of the silicon source to the inert gas is conducive to further adjusting the value of $V_A/V_B$ to an appropriate range. Specifically, when the temperature of the second vapor deposition is higher, the value of $V_A/V_B$ is typically smaller; when the time of the second vapor deposition is longer, the value of $V_A/V_B$ is typically smaller; and when the volume ratio of the silicon source to the inert gas is higher, the value of $V_A/V_B$ is typically smaller.

In some optional embodiments, a positive difference between a pressure of the second vapor deposition and atmospheric pressure is 0.2 KPa-0.6 KPa. For example, it may be but is not limited to 0.2 KPa, 0.25 KPa, 0.3 KPa, 0.35 KPa, 0.4 KPa, 0.45 KPa, 0.5 KPa, 0.55 KPa, 0.6 KPa, or a range defined by any two of the above values.

In some optional embodiments, the silicon source includes one or more of monosilane, disilane, and trisilane.

In some optional embodiments, the inert gas includes one or more of nitrogen and argon.

In some embodiments, the preparation method of the silicon-carbon composite material further includes: placing the silicon-carbon composite material in a mixed gas containing a second carbon source and an inert gas to perform a third vapor deposition to form a carbon coating layer on at least part of an outer surface of the silicon-carbon composite material. Using vapor deposition to prepare the carbon coating layer facilitates the control of a coating amount to enhance the surface conductivity of the silicon-carbon composite material, helps to achieve capacity utilization of the material, and also helps to maintain the stability and safety of the silicon-carbon composite material.

In some optional embodiments, the second carbon source includes one or more of methane, ethylene, and acetylene.

In some optional embodiments, the inert gas includes one or more of nitrogen and argon.

In some optional embodiments, a volume proportion of the second carbon source in the mixed gas is 5%-20%. For example, it may be but is not limited to 5%, 6%, 7%, 8%, 9%, 10%, 11%, 12%, 13%, 14%, 15%, 16%, 17%, 18%, 19%, 20%, or a range defined by any two of the above values. Controlling the volume proportion of the second carbon source in the mixed gas within the above range is conducive to improving the uniformity of carbon coating.

In some optional embodiments, a temperature of the third vapor deposition is 500°C-700°C. For example, it may be but is not limited to 500°C, 510°C, 520°C, 530°C, 540°C, 550°C, 560°C, 570°C, 580°C, 590°C, 600°C, 610°C, 620°C, 630°C, 640°C, 650°C, 660°C, 670°C, 680°C, 690°C, 700°C, or a range defined by any two of the above values. For example, the temperature of the third vapor deposition may be 550°C-650°C. A time of the third vapor deposition is 1 h-6 h. For example, it may be but is not limited to 1 h, 2 h, 3 h, 4 h, 5 h, 6 h, or a range defined by any two of the above values.

It should be noted that the "first carbon source", "second carbon source", "first vapor deposition", "second vapor deposition", "third vapor deposition", "first sintering treatment", and "second sintering treatment" mentioned above are only for descriptive purposes and should not be understood as indicating or implying relative importance or quantity, nor as implicitly indicating the importance or quantity of the indicated technical features.

In some embodiments, the preparation method of the silicon-carbon composite material includes the following steps:

performing a first sintering treatment on a carbon material precursor to prepare a carbon substrate, where a temperature of the first sintering treatment is 400°C-800°C; a sintering time is 1 h-12 h; a sintering atmosphere includes an inert gas; the carbon material precursor includes one or more of a resin carbon material and a biomass carbon material; the resin carbon material includes one or more of phenolic resin, epoxy resin, urea-formaldehyde resin, and furan resin; and the biomass carbon material includes one or more of coconut shell, lignin, bamboo powder, and starch;

performing alkaline etching on the carbon substrate using an alkaline substance to prepare a carbon matrix A having a pore structure, where the alkaline substance includes one or more of potassium hydroxide and sodium hydroxide; a mass ratio of the alkaline substance to the carbon substrate is (2-6): 1;

removing the alkaline substance remaining on the carbon substrate 1 having a pore structure using an acidic substance, then heating and drying, where the acidic substance includes hydrochloric acid;

placing the carbon matrix A having a pore structure in a mixed gas containing a first carbon source and an inert gas to perform a first vapor deposition to prepare a carbon matrix B having a pore structure, where the first carbon source includes one or more of methane, ethylene, and acetylene; the inert gas includes one or more of nitrogen and argon; a volume ratio of the first carbon source to the inert gas is (2-5):10, optionally (2.5-4):10; a temperature of the first vapor deposition is 800°C-1000°C, optionally 850°C-950°C; and a time of the first vapor deposition is 1 h -4 h, optionally 1.5 h-3 h;

placing the carbon matrix B having a pore structure in a mixed gas containing a silicon source and an inert gas to perform a second vapor deposition, where a temperature of the second vapor deposition is 450°C-650°C, optionally 500°C-600°C, and more optionally 520°C-580°C; a time of the second vapor deposition is 4 h-8 h, optionally 4.5 h-7 h, and more optionally 5 h-6 h; a positive difference between a pressure of the second vapor deposition and atmospheric pressure is 0.2 KPa-0.6 KPa; the silicon source includes one or more of monosilane, disilane, and trisilane; the inert gas includes one or more of nitrogen and argon; a volume proportion of the silicon source in the mixed gas is 10%-40%; and a volume proportion of the inert gas in the mixed gas is 60%-90%; and

placing the carbon matrix in a mixed gas containing a second carbon source and an inert gas to perform a third vapor deposition to form a carbon coating layer on at least part of an outer surface of the carbon matrix to prepare the silicon-carbon composite material, where the second carbon source includes one or more of methane, ethylene, and acetylene; the inert gas includes one or more of nitrogen and argon; a volume proportion of the second carbon source in the mixed gas is 5%-20%; a temperature of the third vapor deposition is 500°C-700°C, optionally 550°C-650°C; and a time of the third vapor deposition is 1 h-6 h.

A third aspect of this application provides a secondary battery including a negative electrode plate, where the negative electrode plate includes the silicon-carbon composite material according to the first aspect of this application or a

silicon-carbon composite material prepared by the method according to the second aspect of this application.

In the secondary battery using the above silicon-carbon composite material of this application, both the rate performance and cycling performance are improved.

Typically, a secondary battery includes a positive electrode plate, a negative electrode plate, an electrolyte, and a separator. During charging and discharging of the battery, active ions intercalate and deintercalate back and forth between the positive electrode plate and the negative electrode plate. The electrolyte conducts ions between the positive electrode plate and the negative electrode plate. The separator is disposed between the positive electrode plate and the negative electrode plate to mainly prevent short circuits between positive and negative electrodes and to allow the active ions to pass through.

Negative electrode plate

The negative electrode plate includes a negative electrode current collector and a negative electrode film layer disposed on at least one surface of the negative electrode current collector, where the negative electrode film layer includes the silicon-carbon composite material according to the first aspect of this application or a silicon-carbon composite material prepared by the method according to the second aspect of this application.

As an example, the negative electrode current collector has two opposite surfaces in its thickness direction, and the negative electrode film layer is disposed on either or both of the two opposite surfaces of the negative electrode current collector.

In some embodiments, the negative electrode current collector may use a metal foil or a composite current collector. For example, as the metal foil, a copper foil may be used. The composite current collector may include a polymer material substrate and a metal layer formed on at least one surface of the polymer material substrate. The composite current collector may be formed by forming a metal material on the polymer material substrate. The metal material includes but is not limited to copper, copper alloy, nickel, nickel alloy, titanium, titanium alloy, silver, and silver alloy; and the polymer material substrate includes but is not limited to substrates of polypropylene (PP), polyethylene terephthalate (PET), polybutylene terephthalate (PBT), polystyrene (PS), and polyethylene (PE).

In some embodiments, the negative electrode active material may alternatively use negative electrode active materials known in the art for batteries. As an example, the negative electrode active material may include at least one of the following materials: artificial graphite, natural graphite, soft carbon, hard carbon, a silicon-based material, a tin-based material, lithium titanate, and the like. The silicon-based material may be selected from at least one of elemental silicon, a silicon-nitrogen compound, and a silicon alloy. The tin-based material may be selected from at least one of elemental tin, a tin oxide compound, and a tin alloy. However, this application is not limited to these materials, and other traditional materials that can be used as battery negative electrode active materials can also be used. These negative electrode active materials can be used alone or in combination of two or more. A weight percentage of the negative electrode active material in the negative electrode film layer is 70wt%-100wt% based on a total weight of the negative electrode film layer.

In some embodiments, the negative electrode film layer further optionally includes a binder. The binder may be selected from at least one of styrene-butadiene rubber (SBR), polyacrylic acid (PAA), sodium polyacrylate (PAAS), polyacrylamide (PAM), polyvinyl alcohol (PVA), sodium alginate (SA), polymethacrylic acid (PMAA), and carboxymethyl chitosan (CMCS). A weight percentage of the binder in the negative electrode film layer is 0wt%-30wt% based on the total weight of the negative electrode film layer.

In some embodiments, the negative electrode film layer further optionally includes a conductive agent. The conductive agent may be selected from at least one of superconducting carbon, acetylene black, carbon black, Ketjen black, carbon dots, carbon nanotubes, graphene, and carbon nanofiber. A weight percentage of the conductive agent in the negative electrode film layer is 0wt%-20wt% based on the total weight of the negative electrode film layer.

In some embodiments, the negative electrode film layer further optionally includes other additives such as thickeners (such as sodium carboxymethyl cellulose (CMC-Na)). A weight percentage of the other additives in the negative electrode film layer is 0wt%-15wt% based on the total weight of the negative electrode film layer.

In some embodiments, the negative electrode plate can be prepared by the following method: the components for preparing the negative electrode plate, such as the negative electrode active material, conductive agent, binder, and any other components, are dispersed in a solvent (such as deionized water) to form a negative electrode slurry, where a solid content of the negative electrode slurry is 30wt%-70wt%, and the viscosity at room temperature is adjusted to 2000-10000 mPa·s; and the obtained negative electrode slurry is applied on surfaces of both sides of the negative electrode current collector, followed by drying and cold pressing such as roll pressing to obtain the negative electrode plate. A surface density per unit of the negative electrode powder applied on one side is 75-220 mg/m$^2$, and a compacted density of the negative electrode plate is 1.2-2.0 g/m$^3$.

Positive electrode plate

The positive electrode plate includes a positive electrode current collector and a positive electrode film layer disposed on at least one surface of the positive electrode current collector, where the positive electrode film layer includes a positive electrode active material.

As an example, the positive electrode current collector has two opposite surfaces in its thickness direction, and the positive electrode film layer is disposed on either or both of the two opposite surfaces of the positive electrode current collector.

In some embodiments, the positive electrode current collector may use a metal foil or a composite current collector. For example, as the metal foil, an aluminum foil can be used. The composite current collector may include a polymer material substrate and a metal layer formed on at least one surface of the polymer material substrate. The composite current collector can be formed by forming a metal material on the polymer material substrate. The metal material includes but is not limited to aluminum, aluminum alloy, nickel, nickel alloy, titanium, titanium alloy, silver, and silver alloy. The polymer material substrate includes but is not limited to one or more of polypropylene (PP), polyethylene terephthalate (PET), polybutylene terephthalate (PBT), polystyrene (PS), and polyethylene (PE).

In some embodiments, the lithium-ion positive electrode active material may include positive electrode active materials known in the art for batteries. As an example, the positive electrode active material may include at least one of the following materials: lithium-containing phosphates with olivine structure, lithium transition metal oxides, and their respective modified compounds. However, this application is not limited to these materials, and other traditional materials that can be used as battery positive electrode active materials can also be used. These positive electrode active materials can be used alone or in combination of two or more. Examples of lithium transition metal oxides may include but are not limited to at least one of lithium cobalt oxide (such as $LiCoO_2$), lithium nickel oxide (such as $LiNiO_2$), lithium manganese oxide (such as $LiMnO_2$ or $LiMn_2O_4$), lithium nickel cobalt oxide, lithium manganese cobalt oxide, lithium nickel manganese oxide, lithium nickel cobalt manganese oxide (such as $LiNi_{1/3}Co_{1/3}Mn_{1/3}O_2$ (which can also be abbreviated as NCM333), $LiNi_{0.5}Co_{0.2}Mn_{0.3}O_2$ (which can also be abbreviated as NCM523), $LiNi_{0.5}Co_{0.25}Mn_{0.25}O_2$ (which can also be abbreviated as NCM211), $LiNi_{0.6}Co_{0.2}Mn_{0.2}O_2$ (which can also be abbreviated as NCM622), $LiNi_{0.8}Co_{0.1}Mn_{0.1}O_2$ (which can also be abbreviated as NCM811), lithium nickel cobalt aluminum oxide (such as $LiNi_{0.80}Co_{0.15}Al_{0.05}O_2$), and their modified compounds. Examples of lithium-containing phosphates with olivine structure may include but are not limited to at least one of lithium iron phosphate (such as $LiFePO_4$ (which can also be abbreviated as LFP)), composite materials of lithium iron phosphate and carbon, lithium manganese phosphate (such as $LiMnPO_4$), composite materials of lithium manganese phosphate and carbon, lithium manganese iron phosphate, and composite materials of lithium manganese iron phosphate and carbon. A weight percentage of the positive electrode active material in the positive electrode film layer is 80wt%-100wt% based on a total weight of the positive electrode film layer.

In some embodiments, the positive electrode film layer further optionally includes a binder. As an example, the binder may include at least one of polyvinylidene fluoride (PVDF), polytetrafluoroethylene (PTFE), vinylidene fluoride-tetrafluoroethylene-propylene terpolymer, vinylidene fluoride-hexafluoropropylene-tetrafluoroethylene terpolymer, tetra-fluoroethylene-hexafluoropropylene copolymer, and fluorine-containing acrylate resin. A weight percentage of the binder in the positive electrode film layer is 0wt%-20wt% based on the total weight of the positive electrode film layer.

In some embodiments, the positive electrode film layer further optionally includes a conductive agent. As an example, the conductive agent may include at least one of superconducting carbon, acetylene black, carbon black, Ketjen black, carbon dots, carbon nanotubes, graphene, and carbon nanofiber. A weight percentage of the conductive agent in the positive electrode film layer is 0wt%-20wt% based on the total weight of the positive electrode film layer.

In some embodiments, the positive electrode plate can be prepared by the following method: the components for preparing the positive electrode plate, such as the positive electrode active material, conductive agent, binder, and any other components, are dispersed in a solvent (such as N-methylpyrrolidone) to form a positive electrode slurry, where a solid content of the positive electrode slurry is 40wt%-80wt%, and the viscosity at room temperature is adjusted to 5000-25000 mPa·s; and the positive electrode slurry is applied on surfaces of both sides of the positive electrode current collector, followed by drying and then cold rolling with a cold rolling machine to form the positive electrode plate, where a surface density per unit of the positive electrode powder applied on one side is 15-35 $mg/m^2$, and a compacted density of the positive electrode plate is 3.0-3.6 $g/cm^3$, optionally 3.3-3.5 $g/cm^3$. A calculation formula for the compacted density is as follows:

compacted density = coating surface density / (thickness of the electrode plate after extrusion - thickness of the current collector).

Electrolyte

The electrolyte conducts ions between the positive electrode plate and the negative electrode plate. The type of

the electrolyte is not specifically limited in this application, which can be selected according to needs. For example, the electrolyte may be in a liquid state, a gel state, or an all-solid state.

In some embodiments, the electrolyte uses a liquid electrolyte. The liquid electrolyte solution includes an electrolytic salt and a solvent.

In some embodiments, the electrolytic salt may be selected from one or more of lithium hexafluorophosphate ($LiPF_6$), lithium tetrafluoroborate ($LiBF_4$), lithium perchlorate ($LiClO_4$), lithium hexafluoroarsenate ($LiAsF_6$), lithium bis(fluorosulfonyl)imide (LiFSI), lithium bis(trifluoromethanesulfonyl)imide (LiTFSI), lithium trifluoromethanesulfonate (LiTFS), lithium difluoro(oxalato)borate (LiDFOB), lithium bis(oxalato)borate (LiBOB), lithium difluorophosphate ($LiPO_2F_2$), lithium difluoro bis(oxalato)phosphate (LiDFOP), and lithium tetrafluoro(oxalato)phosphate (LiTFOP). A concentration of the electrolytic salt is typically 0.5-5 mol/L.

In some embodiments, the solvent may be selected from one or more of fluoroethylene carbonate (FEC), ethylene carbonate (EC), propylene carbonate (PC), ethyl methyl carbonate (EMC), diethyl carbonate (DEC), dimethyl carbonate (DMC), dipropyl carbonate (DPC), methyl propyl carbonate (MPC), ethyl propyl carbonate (EPC), butylene carbonate (BC), methyl formate (MF), methyl acetate (MA), ethyl acetate (EA), propyl acetate (PA), methyl propionate (MP), ethyl propionate (EP), propyl propionate (PP), methyl butyrate (MB), ethyl butyrate (EB), gamma-butyrolactone (GBL), sulfolane (SF), dimethyl sulfone (MSM), methyl ethyl sulfone (EMS), and diethyl sulfone (ESE).

In some embodiments, the liquid electrolyte further optionally includes an additive. For example, the additive may include a negative electrode film-forming additive and a positive electrode film-forming additive, and may further include an additive that can improve some performance of the battery, for example, an additive for improving overcharge performance of the battery and an additive for improving high-temperature performance or low-temperature performance of the battery.

Separator

In some embodiments, the secondary battery further includes a separator. The type of the separator is not particularly limited in this application, and any well-known porous structure separator with good chemical stability and mechanical stability may be used.

In some embodiments, the material of the separator may be selected from at least one of glass fiber, non-woven fabric, polyethylene, polypropylene, and polyvinylidene fluoride. The separator can be a single-layer film or a multi-layer composite film, without particular limitation. When the separator is a multi-layer composite film, the materials of the layers may be the same or different, without particular limitation.

In some embodiments, a thickness of the separator is 6-40 μm, optionally 12-20 μm.

In some embodiments, the positive electrode plate, the negative electrode plate, and the separator can be made into an electrode assembly by a winding process or a lamination process; the electrode assembly and the electrolyte are encapsulated using the battery cell packaging material according to the first aspect of this application.

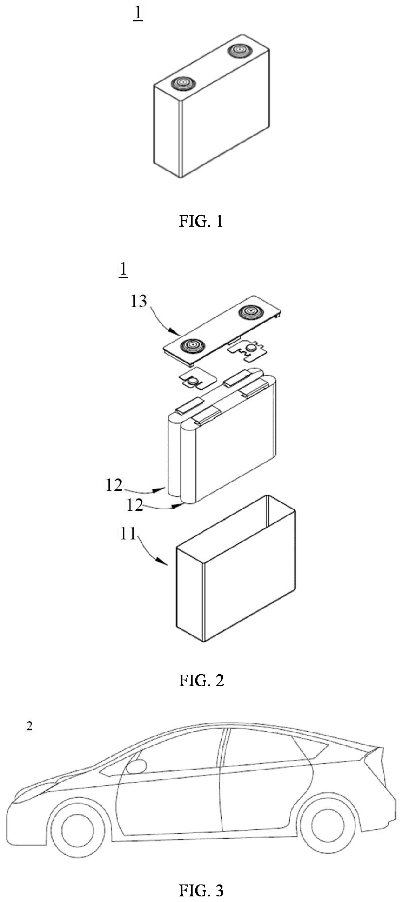

The shape of the secondary battery is not particularly limited in this application, and the secondary battery may be cylindrical, rectangular, or of any other shapes. For example, FIG. 1 is a secondary battery 1 with a rectangular structure as an example.

In some embodiments, referring to FIG. 2, an outer package may include a housing 11 and a cover plate 13. The housing 11 may include a bottom plate and side plates connected to the bottom plate, and the bottom plate and side plates enclose to form an accommodating cavity. The housing 11 has an opening communicating with the accommodating cavity, and the cover plate 13 can cover the opening to close the accommodating cavity.

The positive electrode plate, the negative electrode plate, and the separator can be made into an electrode assembly 12 by a winding process or a lamination process. The electrode assembly 12 is encapsulated in the accommodating cavity. The electrolyte infiltrates the electrode assembly 12. One or more electrode assemblies 12 may be provided in the lithium-ion battery 1, which can be adjusted according to needs.

In some embodiments, the secondary battery may be assembled into a battery module, and a plurality of secondary batteries may be provided in the battery module, and the specific quantity can be adjusted according to the application and capacity of the battery module.

In the battery module, the plurality of secondary batteries can be arranged in sequence along a length direction of the battery module. Certainly, the secondary batteries may alternatively be arranged in any other manner. Further, the plurality of lithium-ion batteries can be fixed by fasteners.

Optionally, the battery module may further include an enclosure with an accommodating space, and the plurality of secondary batteries are accommodated in the accommodating space.

In some embodiments, the above battery module may further be assembled into a battery pack, and the quantity of battery modules provided in the battery pack can be adjusted according to the application and capacity of the battery pack.

The battery pack may include a battery box and a plurality of battery modules disposed in the battery box. The

battery box includes an upper box body and a lower box body, where the upper box body can fit the lower box body to form a closed space for accommodating the battery modules. The plurality of battery modules may be arranged in the battery box in any manner.

Electric apparatus

A fourth aspect of this application provides an electric apparatus, where the electric apparatus includes at least one of the secondary battery, battery module, or battery pack according to the third aspect of this application. The secondary battery, battery module, or battery pack can be used as a power source of the apparatus or as an energy storage unit of the apparatus. The apparatus may be but is not limited to a mobile device, an electric vehicle, an electric train, a ship, a satellite system, and an energy storage system. The mobile device may include but is not limited to at least one of a mobile phone and a notebook computer. The electric vehicle may include but is not limited to at least one of a battery electric vehicle, a hybrid electric vehicle, a plug-in hybrid electric vehicle, an electric bicycle, an electric scooter, an electric golf cart, and electric truck.

For the apparatus, a secondary battery, a battery module, or a battery pack may be selected according to requirements for using the apparatus.

FIG. 3 is an electric apparatus 2 as an example. The electric apparatus 2 is a battery electric vehicle, a hybrid electric vehicle, or a plug-in hybrid electric vehicle. To satisfy requirements of the apparatus for high power and high energy density of a secondary battery, a battery pack or a battery module may be used.

As another example, the apparatus may be a mobile phone, a tablet computer, a notebook computer, or the like. The apparatus is typically required to be light and thin, and may use a lithium-ion battery as its power source.

The beneficial effects of this application will be further described below in conjunction with embodiments.

In order to make the technical problems solved by this application, the technical solutions, and the beneficial effects clearer, this application will be further described in detail below in conjunction with embodiments and drawings. Apparently, the described embodiments are only some rather than all of these embodiments of this application. The following description of at least one exemplary embodiment is merely illustrative and definitely is not construed as any limitation on this application or on use of this application. Based on the embodiments in this application, all other embodiments obtained by persons of ordinary skill in the art without creative efforts fall within the protection scope of this application.

Examples whose technical solutions or conditions are not specified are made in accordance with technical solutions or conditions described in literature in the field or made in accordance with product instructions. The reagents or instruments used are all conventional products that are commercially available if no manufacturer is indicated. As an example, phenolic resin can be purchased from Jining Huakai Resin Co., Ltd.

I. Preparation of silicon-carbon composite material

Example 1

Step 1: 1 kg of coconut shell (as a carbon material precursor) was weighed and placed in a box furnace, nitrogen was introduced, the temperature was raised to 600°C at a heating velocity of 5°C/min, the temperature was maintained at 600°C for 2 h to perform a first sintering treatment, and after the furnace was cooled, a carbon substrate was taken out.

Step 2: Potassium hydroxide (as an alkaline substance) and the carbon substrate were mixed at a mass ratio of 4:1, the resulting mixture was placed in a box furnace, nitrogen was introduced, the temperature was raised to 800°C at a heating velocity of 5°C/min, and the temperature was maintained at 800°C for 4 h, and then a pore formation treatment was performed.

Step 3: The carbon substrate after the pore formation treatment was mixed well with 0.1 mol/L hydrochloric acid solution (as an acidic substance), the potassium hydroxide remaining in the carbon matrix was removed, and then heating and drying were performed at 80°C for 12 h.

Step 4: The carbon substrate after the pore formation treatment was placed in a vapor deposition rotary furnace, acetylene (as a first carbon source) and nitrogen were mixed at a volume ratio of 2:10, the temperature was raised to 950°C at a heating velocity of 5°C/min, a first vapor deposition was performed for 2 h to adjust a pore diameter, and a carbon matrix having a pore structure was prepared.

Step 5: The carbon matrix was placed in a vapor deposition furnace, and the temperature was raised to 500°C at 5°C/min; a mixed gas of monosilane (as a silicon source) and nitrogen was introduced, where a volume proportion of monosilane was 20%, a volume proportion of nitrogen was 80%, and a total gas flow rate was 5 L/min; and a pressure in the furnace was controlled to be slightly higher than atmospheric pressure by 200 Pa for performing a second vapor deposition for 6 h.

Step 6: The introduction of monosilane was stopped, and the temperature continued to rise to 600°C; a mixed gas

of acetylene (as a second carbon source) and nitrogen was introduced, where a volume proportion of acetylene was 20%, and a volume proportion of nitrogen was 80%; a third vapor deposition was performed for 1 h; and after cooling and sieving were performed, a silicon-carbon composite material was obtained.

The preparation methods of Examples 2 to 5 were similar to that of Example 1, with differences detailed in Table 1.

Comparative Example 1

The preparation method of Comparative Example 1 was similar to that of Example 1, with the difference that: during preparation of the silicon-carbon composite material, the step of the first vapor deposition was not used.

Comparative Examples 2 to 4

The preparation methods of Comparative Examples 2 to 4 were similar to that of Example 1, with differences detailed in Table 1.

Table 1

| Group | First sintering treatment | | | Pore formation treatment | | | | First vapor deposition | | | | Second vapor deposition | | | | Third vapor deposition | | | |
|---|---|---|---|---|---|---|---|---|---|---|---|---|---|---|---|---|---|---|---|
| | Carbon material precursor | T1 (°C) | t1 (h) | Alkaline substance | n1 | T2 (°C) | t2 (h) | First carbon source | n2 | T3 (°C) | t3 (h) | Silicon source | n3 | T4 (°C) | t4 (h) | Second carbon source | n4 | T5 (°C) | t5 (h) |
| Example 1 | Coconut shell | 600 | 4 | KOH | 4:01 | 800 | 4 | Acetylene | 2: 10 | 950 | 2 | Monosilane | 20% | 500 | 6 | Acetylene | 20% | 600 | 1 |
| Example 2 | Bamboo powder | 800 | 3 | KOH | 2:01 | 800 | 4 | Acetylene | 2:10 | 850 | 3 | Monosilane | 20% | 520 | 6 | Acetylene | 20% | 600 | 1 |
| Example 3 | Bamboo powder | 800 | 2 | KOH | 3:01 | 800 | 4 | Acetylene | 2:10 | 850 | 1.5 | Monosilane | 20% | 500 | 6 | Acetylene | 20% | 600 | 1 |
| Example 4 | Coconut shell | 700 | 3 | KOH | 4:01 | 800 | 4 | Acetylene | 2:10 | 850 | 2 | Monosilane | 20% | 540 | 6 | Acetylene | 20% | 600 | 1 |
| Example 5 | Phenolic resin | 700 | 3 | KOH | 3:01 | 800 | 4 | Acetylene | 2:10 | 850 | 2 | Monosilane | 20% | 500 | 6 | Acetylene | 20% | 600 | 1 |
| Comparative Example 1 | Coconut shell | 600 | 4 | KOH | 4:01 | 800 | 4 | / | / | / | / | Monosilane | 20% | 500 | 6 | Acetylene | 20% | 600 | 1 |
| Comparative Example 2 | Coconut shell | 600 | 4 | KOH | 4:01 | 800 | 4 | Acetylene | 2:10 | 700 | 2 | Monosilane | 20% | 500 | 6 | Acetylene | 20% | 600 | 1 |
| Comparative Example 3 | Coconut shell | 600 | 4 | KOH | 4:01 | 800 | 4 | Acetylene | 2:10 | 700 | 2 | Monosilane | 20% | 500 | 6 | Acetylene | 20% | 800 | 1 |
| Comparative Example 4 | Coconut shell | 600 | 4 | KOH | 4:01 | 800 | 4 | Acetylene | 2:10 | 700 | 2 | Monosilane | 20% | 750 | 6 | Acetylene | 20% | 800 | 1 |

Here, n1 represents the mass ratio of the alkaline substance to the carbon substrate, n2 represents the volume ratio of the first carbon source to the inert gas, n3 represents the volume proportion of the silicon source in the mixed gas during the second vapor deposition, n4 represents the volume proportion of the second carbon source in the mixed gas during the third vapor deposition, T1 represents the temperature of the first sintering treatment, t1 represents the time of the first sintering treatment, T2 represents the sintering temperature during the pore formation treatment, t2 represents the sintering time during the pore formation treatment, T3 represents the temperature of the first vapor deposition, t3 represents the time of the first vapor deposition, T4 represents the temperature of the second vapor deposition, t4 represents the time of the second vapor deposition, T5 represents the temperature of the third vapor deposition, t5 represents the time of the third vapor deposition, and the pressure difference represents the difference between the pressure of the second vapor deposition and atmospheric pressure.

II. Preparation of button battery

1. Negative electrode plate

The silicon-carbon composite material prepared above, conductive carbon black, and a binder polyacrylic acid were mixed at a mass ratio of 8:1:1, deionized water was added, and the resulting mixture was stirred well to form a negative electrode slurry; the negative electrode slurry was evenly applied on one surface of a negative electrode current collector copper foil; and after drying and cold pressing were performed, a negative electrode plate was obtained.

2. Electrolyte

Ethylene carbonate (EC), ethyl methyl carbonate (EMC), and diethyl carbonate (DEC) were mixed at a volume ratio of 20:20:60; then, $LiPF_6$ was evenly dissolved in the above solution; an additive fluoroethylene carbonate (FEC) was obtained; and an electrolyte was obtained. In the electrolyte, a concentration of $LiPF_6$ was 1 mol/L, and a mass proportion of FEC in the electrolyte was 5%.

3. Separator

A polyethylene film was used as a separator.

4. Preparation of button battery

The above negative electrode plate was used as a working electrode, and metallic lithium was used as a counter electrode; the negative electrode plate, the separator, and metallic lithium were stacked in order, so that the separator was located between the working electrode and the counter electrode; the above electrolyte was injected; and the resulting product was assembled to obtain a button battery.

III. Preparation of secondary battery (full battery)

1. Negative electrode plate

The silicon-carbon composite material prepared above, conductive agent carbon nanotubes and SP mixture, a binder styrene-butadiene rubber, and a thickener sodium carboxymethyl cellulose were stirred and mixed well in an appropriate amount of solvent deionized water at a weight ratio of 95.5:1:2:1.5 to form a negative electrode slurry. The negative electrode slurry was applied on both surfaces of a negative electrode current collector copper foil, followed by drying and cold pressing, to obtain a negative electrode plate.

2. Positive electrode plate

A positive electrode active material LiNi0.8Co0.1Mn0.1O2 (NCM811) was mixed with conductive carbon black and polyvinylidene fluoride at a weight ratio of 97.5:1.2:1.3, and an appropriate amount of solvent NMP was added. The resulting mixture was stirred well to obtain a positive electrode slurry. The positive electrode slurry was applied on both surfaces of a positive electrode current collector aluminum foil, followed by drying and cold pressing, to obtain a positive electrode plate.

3. Electrolyte

A mixed solution of ethylene carbonate (EC), ethyl methyl carbonate (EMC), and diethyl carbonate (DEC) was used as an organic solvent, where a volume ratio of EC, EMC, and DEC was 20%:20%:60%. In an argon atmosphere glove box with a water content less than 10 ppm, a fully dried lithium salt (LiPF6) was dissolved in the above organic solvent, an additive fluoroethylene carbonate (FEC) was added, and an electrolyte was obtained. In the electrolyte, a concentration of $LiPF_6$ was 1 mol/L, and a mass proportion of FEC in the electrolyte was 5%.

4. Separator

A polyethylene film was used as a separator.

5. Preparation of secondary battery

The separator and the positive electrode plate and negative electrode plate prepared above were placed in order, so that the separator was located between the positive electrode plate and the negative electrode plate for isolation. Then, the resulting product was wound to obtain an electrode assembly. The electrode assembly was placed in an outer packaging, dried, and injected with the electrolyte prepared above. After processes such as vacuum encapsulation, standing, formation, and capacity testing were performed, a pouch secondary battery was obtained. A size of the secondary battery was 135 mm × 72 mm × 60 mm, and a capacity was 4.65 Ah.

III. Battery performance test

1. First-cycle charge-discharge efficiency

After left standing for 60 min, the button battery prepared above was discharged at a constant current of 0.05C to 5 mV, discharged at 50 μA to 5 mV, left standing for 10 min, and charged at 0.1C to 1.5 V. A delithiation capacity at 1.5 V represented a capacity of a sample under test. First-cycle charge-discharge efficiency = delithiation capacity at 1.5 V/lithiation capacity × 100%. The results were shown in Table 2.

2. $V_A/V_B$

After left standing for 60 min, the button battery prepared above was discharged at a constant current of 0.05C to 5 mV, discharged at 50 μA to 5 mV, left standing for 10 min, and charged at 0.1C to 1.5 V. A curve graph of a relationship between a differential value dQ/dV obtained by differentiating a working electrode potential V with respect to a charge-discharge capacity Q and the working electrode potential V was plotted. During delithiation-direction energization of a negative electrode material, a maximum value of the differential value dQ/dV within a range of 0.26 V-0.33 V was denoted as $V_A$, a maximum value of the differential value dQ/dV within a range of 0.42 V-0.52 V was denoted as $V_B$, and a value of $V_A/V_B$ was calculated. The results were shown in Table 2.

FIG. 5 was a curve graph of a relationship between a differential value dQ/dV and a working electrode potential V of a battery cell prepared using a silicon-carbon composite material in Example 3. It could be seen from FIG. 5 that $V_A/V_B$ of the battery cell was 1.62.

3. Cycling performance test

At 25°C, the secondary battery (full battery) prepared above was charged at 0.5C to 4.25 V and then discharged at 1C to 2.5 V. This was one charge-discharge cycle process. A discharge capacity at that point was recorded as an initial discharge capacity. The secondary battery continued to undergo charge-discharge cycle test according to the above method. A discharge capacity after each cycle was recorded until the discharge capacity of the secondary battery decayed to 80% of the initial discharge capacity, and the number of cycles at that point was recorded.

Table 2

| Group | $V_A/V_B$ | First-cycle charge-discharge efficiency | Cycling performance (cycles) |
|---|---|---|---|
| Example 1 | 1.55 | 82.3% | 943 |
| Example 2 | 1.59 | 81.9% | 1023 |
| Example 3 | 1.62 | 82.1% | 1107 |

(continued)

| Group | $V_A/V_B$ | First-cycle charge-discharge efficiency | Cycling performance (cycles) |
|---|---|---|---|
| Example 4 | 1.71 | 82.9% | 1265 |
| Example 5 | 1.99 | 82.7% | 1147 |
| Comparative Example 1 | 1.32 | 81.0% | 557 |
| Comparative Example 2 | 1.38 | 81.4% | 589 |
| Comparative Example 3 | 1.34 | 81.2% | 572 |
| Comparative Example 4 | 1.25 | 81.7% | 335 |

From the comparison of the results of the examples and comparative examples in Table 2, it can be seen that the silicon-carbon composite material of this application includes a carbon matrix having a pore structure and a silicon-based material distributed in the pore structure of the carbon matrix, and controlling $V_A/V_B$ of the material to be greater than or equal to 1.4 can significantly improve the first-cycle charge-discharge efficiency and cycling performance of the silicon-carbon composite material.

In Comparative Example 1, during preparation of the silicon-carbon composite material, no first vapor deposition treatment is performed, no pore diameter adjustment is made to the pore structure, the pore diameter of the pore structure is large, resulting in the deposition of the silicon-based material on the surface of the carbon matrix, with a large grain size of the silicon-based material, thereby causing $V_A/V_B$ of the prepared silicon-carbon composite material to be less than 1.4, unable to significantly improve the first-cycle charge-discharge efficiency and cycling performance of the silicon-carbon composite material.

In Comparative Example 2, during preparation of the silicon-carbon composite material, the temperature of the first vapor deposition is low, the pretreatment of the pore structure is insufficient, the proportion of micropores is low, and part of the silicon-based material is deposited on the surface of the carbon matrix, with a large grain size of the silicon-based material, making $V_A/V_B$ of the silicon-carbon composite material be less than 1.4.

In Comparative Example 3, during preparation of the silicon-carbon composite material, the temperature of the first vapor deposition is low, the pretreatment of the pore structure is insufficient, the proportion of micropores is low, and part of the silicon-based material is deposited on the surface of the carbon matrix, with a large grain size of the silicon-based material; and the temperature of the third vapor deposition is high, leading to further growth of silicon grains, making $V_A/V_B$ of the finally prepared silicon-carbon composite material be less than 1.4.

In Comparative Example 4, during preparation of the silicon-carbon composite material, the temperature of the first vapor deposition is low, the pretreatment of the pore structure is insufficient, and the proportion of micropores is low; and the temperature of the second vapor deposition is excessively high, the decomposition speed of the silicon-based material is accelerated, most of the silicon-based material is deposited on the surface of the carbon matrix, and silicon grain aggregation facilitates rapid grain growth, making $V_A/V_B$ of the silicon-carbon composite material be less than 1.4. The technical features of the above embodiments can be combined arbitrarily. To make the description concise, not all possible combinations of the technical features in the above embodiments are described. However, as long as there is no contradiction in the combination of these technical features, they should be considered as within the scope recorded in this specification.

The foregoing embodiments represent only several implementations of this application, and descriptions thereof are specific and detailed, but should not be construed as any limitations on the scope of this application. It should be noted that persons of ordinary skill in the art can further make several modifications and improvements without departing from the concept of this application, and all these modifications and improvements fall within the protection scope of this application. Therefore, the protection scope of this application should be subject to the appended claims.

## Claims

**1.** A silicon-carbon composite material, comprising:

a carbon matrix, wherein the carbon matrix has a pore structure; and
a silicon-based material distributed in the pore structure of the carbon matrix;
wherein a button battery is used to charge and discharge the silicon-carbon composite material, a curve graph of a relationship between a differential value dQ/dV obtained by differentiating a voltage V of a charge-discharge curve of the button battery with respect to a charge-discharge capacity Q and the voltage V is plotted, a maximum value

of the differential value dQ/dV within a range of 0.26 V-0.35 V is denoted as $V_A$, a maximum value of the differential value dQ/dV within a range of 0.42 V-0.52 V is denoted as $V_B$, and the silicon-carbon composite material satisfies: $V_A/V_B \geq 1.40$.

**2.** The silicon-carbon composite material according to claim 1, wherein $1.42 \leq V_A/V_B \leq 1.90$.

**3.** The silicon-carbon composite material according to claim 1 or 2, wherein $1.50 \leq V_A/V_B \leq 1.70$.

**4.** The silicon-carbon composite material according to any one of claims 1 to 3, wherein a grain size of the silicon-based material is less than or equal to 6 nm.

**5.** The silicon-carbon composite material according to any one of claims 1 to 4, wherein a pore diameter of the pore structure is 0.5 nm-8 nm.

**6.** The silicon-carbon composite material according to any one of claims 1 to 5, wherein the pore structure comprises micropores with a pore diameter greater than or equal to 0.5 nm and less than 2 nm and mesopores with a pore diameter of 2 nm-8 nm.

**7.** The silicon-carbon composite material according to claim 6, wherein a quantity proportion of the micropores in the pore structure is 60%-90%.

**8.** The silicon-carbon composite material according to any one of claims 1 to 7, wherein a specific surface area of the silicon-carbon composite material is 2 $m^2/g$-10 $m^2/g$.

**9.** The silicon-carbon composite material according to any one of claims 1 to 8, wherein the silicon-carbon composite material has at least one of the following features:

(1) the silicon-based material comprises elemental silicon;
(2) a shape of the silicon-based material comprises one or more of a spherical shape, a quasi-spherical shape, a flaky shape, and a linear shape;
(3) a specific surface area of the carbon matrix is 1000 $m^2/g$-2000 $m^2/g$;
(4) a mass proportion of the silicon-based material in the silicon-carbon composite material is 35%-60%;
(5) a particle size by volume $D_v50$ of the silicon-carbon composite material is 3 $\mu$m-15 $\mu$m;
(6) a particle size by volume $D_v90$ of the silicon-carbon composite material is less than or equal to 50 $\mu$m;
(7) the silicon-carbon composite material satisfies: $1 \leq (D_v90-D_v10)/D_v50 \leq 3$;
(8) a tap density of the silicon-carbon composite material is 0.8 $g/cm^3$-1.2 $g/cm^3$; and
(9) a powder resistivity of the silicon-carbon composite material at 16 MPa is less than or equal to 5 $\Omega \cdot m$.

**10.** The silicon-carbon composite material according to any one of claims 1 to 9, wherein at least part of an outer surface of the silicon-carbon composite material further comprises a carbon coating layer.

**11.** The silicon-carbon composite material according to claim 10, wherein the carbon coating layer has at least one of the following features:

(1) a material of the carbon coating layer comprises amorphous carbon; and
(2) a thickness of the carbon coating layer is 30 nm-200 nm.

**12.** A preparation method of the silicon-carbon composite material according to any one of claims 1 to 11, comprising the following steps:

preparing a carbon substrate;
performing a pore formation treatment on the carbon substrate to obtain a carbon matrix A having a pore structure;
performing a pore diameter adjustment treatment on the carbon matrix A having a pore structure to obtain a carbon matrix B having a pore structure; and
depositing a silicon-based material in the pore structure of the carbon matrix B having a pore structure to prepare the silicon-carbon composite material, wherein a button battery is used to charge and discharge the silicon-carbon composite material, a curve graph of a relationship between a differential value dQ/dV obtained by differentiating a voltage V of a charge-discharge curve of the button battery with respect to a charge-discharge

capacity Q and the voltage V is plotted, a maximum value of the differential value dQ/dV within a range of 0.26 V-0.35 V is denoted as $V_A$, a maximum value of the differential value dQ/dV within a range of 0.42 V-0.52 V is denoted as $V_B$, and the silicon-carbon composite material satisfies: $V_A/V_B \geq 1.40$.

**13.** The preparation method of the silicon-carbon composite material according to claim 12, wherein the step of preparing a carbon substrate comprises: performing a first sintering treatment on a carbon material precursor to prepare the carbon substrate.

**14.** The preparation method of the silicon-carbon composite material according to claim 13, wherein a preparation method of the carbon substrate satisfies at least one of the following conditions:

(1) a temperature of the first sintering treatment is 400°C-800°C;
(2) a time of the first sintering treatment is 1 h-12 h;
(3) an atmosphere of the first sintering treatment comprises an inert gas;
(4) the inert gas comprises one or more of nitrogen and argon; and
(5) the carbon material precursor comprises one or more of a resin carbon material and a biomass carbon material.

**15.** The preparation method of the silicon-carbon composite material according to any one of claims 12 to 14, wherein the step of the pore formation treatment comprises: performing alkaline etching on the carbon substrate using an alkaline substance.

**16.** The preparation method of the silicon-carbon composite material according to claim 15, wherein the pore formation treatment satisfies at least one of the following conditions:

(1) the alkaline substance comprises one or more of potassium hydroxide and sodium hydroxide; and
(2) a mass ratio of the alkaline substance to the carbon substrate is (2-6):1.

**17.** The preparation method of the silicon-carbon composite material according to any one of claims 12 to 16, wherein the step of the pore diameter adjustment treatment comprises: placing the carbon matrix A having a pore structure in a mixed gas containing a first carbon source and an inert gas to perform a first vapor deposition.

**18.** The preparation method of the silicon-carbon composite material according to claim 17, wherein a temperature of the first vapor deposition is 800°C-1000°C.

**19.** The preparation method of the silicon-carbon composite material according to claim 17 or 18, wherein the temperature of the first vapor deposition is 850°C-950°C.

**20.** The preparation method of the silicon-carbon composite material according to any one of claims 17 to 19, wherein a time of the first vapor deposition is 1 h-4 h.

**21.** The preparation method of the silicon-carbon composite material according to any one of claims 17 to 20, wherein a volume ratio of the first carbon source to the inert gas is (2-5): 10.

**22.** The preparation method of the silicon-carbon composite material according to any one of claims 17 to 21, wherein the first vapor deposition further comprises at least one of the following conditions:

(1) the first carbon source comprises one or more of methane, ethylene, and acetylene; and
(2) the inert gas comprises one or more of nitrogen and argon.

**23.** The preparation method of the silicon-carbon composite material according to any one of claims 12 to 22, wherein the carbon matrix B having a pore structure is placed in a mixed gas containing a silicon source and an inert gas to perform a second vapor deposition.

**24.** The preparation method of the silicon-carbon composite material according to claim 23, wherein a temperature of the second vapor deposition is 450°C-650°C.

**25.** The preparation method of the silicon-carbon composite material according to claim 23 or 24, wherein the temperature

of the second vapor deposition is 500°C-600°C.

**26.** The preparation method of the silicon-carbon composite material according to any one of claims 23 to 25, wherein a time of the second vapor deposition is 4 h-8 h.

**27.** The preparation method of the silicon-carbon composite material according to any one of claims 23 to 26, wherein the second vapor deposition comprises at least one of the following conditions:

(1) a volume proportion of the silicon source in the mixed gas is 10%-40%; and
(2) a volume proportion of the inert gas in the mixed gas is 60%-90%.

**28.** The preparation method of the silicon-carbon composite material according to any one of claims 23 to 27, wherein the second vapor deposition further comprises at least one of the following conditions:

(1) a positive difference between a pressure of the second vapor deposition and atmospheric pressure is 0.2 KPa-0.6 KPa;
(2) the silicon source comprises one or more of monosilane, disilane, and trisilane; and
(3) the inert gas comprises one or more of nitrogen and argon.

**29.** The preparation method of the silicon-carbon composite material according to any one of claims 12 to 28, wherein before the step of the pore diameter adjustment treatment, the preparation method further comprises: removing, using an acidic substance, the alkaline substance remaining on the carbon substrate after the pore formation treatment.

**30.** The preparation method of the silicon-carbon composite material according to any one of claims 12 to 29, wherein the preparation method further comprises: placing the silicon-carbon composite material in a mixed gas containing a second carbon source and an inert gas to perform a third vapor deposition to form a carbon coating layer on at least part of an outer surface of the silicon-carbon composite material.

**31.** The preparation method of the silicon-carbon composite material according to claim 30, wherein the third vapor deposition satisfies at least one of the following conditions:

(1) the second carbon source comprises one or more of methane, ethylene, and acetylene;
(2) the inert gas comprises one or more of nitrogen and argon;
(3) a volume proportion of the second carbon source in the mixed gas is 5%-20%;
(4) a temperature of the third vapor deposition is 500°C-700°C; and
(5) a time of the third vapor deposition is 1 h-6 h.

**32.** A secondary battery, comprising a negative electrode plate, wherein the negative electrode plate comprises the silicon-carbon composite material according to any one of claims 1 to 11 or a silicon-carbon composite material prepared by the method according to any one of claims 12 to 31.

**33.** An electric apparatus, comprising the secondary battery according to claim 32.

1

FIG. 1

1
13
12
12
11

FIG. 2

2

FIG. 3

412
411

FIG. 4

6000
5000
4000
3000
2000
1000
0
dQ/dV (mAh/V)
0
0.5
1
1.5
2
Voltage (V)

FIG. 5

## INTERNATIONAL SEARCH REPORT

International application No.
**PCT/CN2024/089369**

**A. CLASSIFICATION OF SUBJECT MATTER**

H01M4/36(2006.01)i; H01M4/38(2006.01)i; H01M4/583(2010.01)i; H01M4/62(2006.01)i; H01M10/0525(2010.01)i; C01B32/05(2017.01)i; C01B33/029(2006.01)i

According to International Patent Classification (IPC) or to both national classification and IPC

**B. FIELDS SEARCHED**

Minimum documentation searched (classification system followed by classification symbols)

IPC: H01M4/-; H01M10/-; C01B32/-; C01B33/-

Documentation searched other than minimum documentation to the extent that such documents are included in the fields searched

Electronic data base consulted during the international search (name of data base and, where practicable, search terms used)

CNTXT, ENTXTC, DWPI, CNKI: 电池, 硅, Si, 碳, 炭, 孔, 沉积, 充电, 放电, 充放电, 电压, +容量, battery, silicon, carbon, pore, hole, deposit+, charge, discharge, voltage, capacity

**C. DOCUMENTS CONSIDERED TO BE RELEVANT**

| Category* | Citation of document, with indication, where appropriate, of the relevant passages | Relevant to claim No. |
|---|---|---|
| PX | CN 117096330 A (CONTEMPORARY AMPEREX TECHNOLOGY CO., LTD.) 21 November 2023 (2023-11-21)<br>claims 1-33 | 1-33 |
| A | CN 114520313 A (HUAWEI TECHNOLOGIES CO., LTD.) 20 May 2022 (2022-05-20)<br>claims 1-20 | 1-33 |
| A | CN 116598452 A (JIANGMEN HECHUANG NEW ENERGY MATERIAL CO., LTD.) 15 August 2023 (2023-08-15)<br>claims 1-10 | 1-33 |
| A | CN 115763769 A (NINGDE AMPEREX TECHNOLOGY LTD.) 07 March 2023 (2023-03-07)<br>entire document | 1-33 |
| A | CN 116259727 A (BEIJING WELION NEW ENERGY TECHNOLOGY CO., LTD.) 13 June 2023 (2023-06-13)<br>entire document | 1-33 |

☑ Further documents are listed in the continuation of Box C. ☑ See patent family annex.

* Special categories of cited documents:
- "A" document defining the general state of the art which is not considered to be of particular relevance
- "D" document cited by the applicant in the international application
- "E" earlier application or patent but published on or after the international filing date
- "L" document which may throw doubts on priority claim(s) or which is cited to establish the publication date of another citation or other special reason (as specified)
- "O" document referring to an oral disclosure, use, exhibition or other means
- "P" document published prior to the international filing date but later than the priority date claimed
- "T" later document published after the international filing date or priority date and not in conflict with the application but cited to understand the principle or theory underlying the invention
- "X" document of particular relevance; the claimed invention cannot be considered novel or cannot be considered to involve an inventive step when the document is taken alone
- "Y" document of particular relevance; the claimed invention cannot be considered to involve an inventive step when the document is combined with one or more other such documents, such combination being obvious to a person skilled in the art
- "&" document member of the same patent family

| Date of the actual completion of the international search | Date of mailing of the international search report |
|---|---|
| **26 June 2024** | **03 July 2024** |

| Name and mailing address of the ISA/CN | Authorized officer |
|---|---|
| **China National Intellectual Property Administration (ISA/CN)**<br>**China No. 6, Xitucheng Road, Jimenqiao, Haidian District, Beijing 100088** | <br>Telephone No. |

Form PCT/ISA/210 (second sheet) (July 2022)

INTERNATIONAL SEARCH REPORT

International application No.
**PCT/CN2024/089369**

**C. DOCUMENTS CONSIDERED TO BE RELEVANT**

| Category* | Citation of document, with indication, where appropriate, of the relevant passages | Relevant to claim No. |
|---|---|---|
| A | WO 2022193286 A1 (NINGDE AMPEREX TECHNOLOGY LTD.) 22 September 2022 (2022-09-22) entire document | 1-33 |
| A | WO 2023093448 A1 (HUNAN ZHONGKE SHINZOOM CO., LTD.) 01 June 2023 (2023-06-01) entire document | 1-33 |

Form PCT/ISA/210 (second sheet) (July 2022)

**INTERNATIONAL SEARCH REPORT**
**Information on patent family members**

International application No.
**PCT/CN2024/089369**

| Patent document cited in search report | Publication date (day/month/year) | Patent family member(s) | Publication date (day/month/year) |
|---|---|---|---|
| CN 117096330 A | 21 November 2023 | None | |
| CN 114520313 A | 20 May 2022 | None | |
| CN 116598452 A | 15 August 2023 | None | |
| CN 115763769 A | 07 March 2023 | None | |
| CN 116259727 A | 13 June 2023 | None | |
| WO 2022193286 A1 | 22 September 2022 | None | |
| WO 2023093448 A1 | 01 June 2023 | None | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- CN 202311360972
- GB 190772016 T
- GB 195872017 T
- GB 51622006 T